# EUROPÄISCHE PATENTSCHRIFT

(11) **EP 1 176 706 B1**
(45) Veröffentlichungstag und Bekanntmachung des Hinweises auf die Patenterteilung: **15.12.2004**
(21) Anmeldenummer: 01117064.4
(22) Anmeldetag: 13.07.2001
(51) Int. Cl.: H05K 7/14, H05K 7/20

(54) **Frequenzumrichter mit einem aus Oberteil und Unterteil bestehenden Gehäuse**
Frequency converter with a housing consisting in an upper part and a lower part
Convertisseur de fréquence avec un boîtier consistant en une partie supérieure et une partie inférieure

(30) Priorität: 26.07.2000 DE 10036234
(43) Veröffentlichungstag der Anmeldung: 30.01.2002
(73) Patentinhaber: Lenze Drive Systems GmbH, 31855 Aerzen (DE)
(72) Erfinder: Kalt, Christoph, 9462 Montlingen (CH); Staeheli, Curdin, Ottikon bei Kemptthal (CH); Schmidhauser, Rolf, 8590 Romanshorn (CH); Willerich, Kay, 31860 Emmerthal (DE); Rohde, Matthias, 30982 Pattensen (DE)
(74) Vertreter: Elbertzhagen, Otto, Dipl.-Ing.

(56) Entgegenhaltungen:
- DE-A- 19 704 226
- DE-A- 19 726 258
- US-A- 5 793 611
- PATENT ABSTRACTS OF JAPAN vol. 1998, no. 11, 30. September 1998 (1998-09-30) & JP 10 150284 A (YASKAWA ELECTRIC CORP), 2. Juni 1998 (1998-06-02)

## Beschreibung

Die Erfindung bezieht sich auf einen Frequenzumrichter der im Gattungsbegriff des Patentanspruchs 1 näher bezeichneten Art.

Solche Frequenzumrichter dienen der Drehzahlsteuerung von Elektromotoren, bei denen es sich um Drehfeldmaschinen, insbesondere um Asynchronmaschinen, handelt. In zunehmenden Maße werden die Frequenzumrichter unmittelbar an der Außenseite des Motorgehäuses angebaut, um eine besonders kompakte Bauform zu erzielen. Dadurch verringert sich der Verdrahtungsaufwand zwischen dem Umrichter und den Motorwicklungen aufgrund kurzer Leitungen, zudem entstehen geringere Störemissionen.

Der zu einem Elektromotor passende Frequenzumrichter benötigt ein Leistungsmodul, welches an die Motorleistung angepaßt ist. Ein solches Leistungsmodul erzeugt in Relation zu den übrigen Bauteilen des Frequenzumrichters eine hohe Verlustwärme, die abgeführt werden muß. Dazu sind die Kühlflächen am Gehäuseoberteil des Frequenzumrichters vorgesehen, von denen die Wärme in der Regel durch erzwungene Konvektion abgeführt wird. Dafür kann der vorhandene Motorlüfter oder ein Fremdlüfter vorgesehen werden. Ein solcher Frequenzumrichter mit den im ersten Teil des Anspruchs 1 genannten Merkmalen ist aus DE-A-19704226 bekannt.

Bei den Frequenzumrichtern bekannter Bauart findet über die Kühlflächen des Gehäuseoberteils ein Wärmeaustausch statt, wodurch die Wärmeabfuhr von den übrigen Bauteilen gegenüber der Wärmeabfuhr vom Leistungsmodul beeinträchtigt wird.

Der Erfindung liegt deshalb die Aufgabe zugrunde, einen Frequenzumrichter der eingangs genannten Art zu schaffen, an dessen Gehäuse eine Trennung der Kühlflächen, die zum einen dem Leistungsmodul und die zum anderen den weiteren elektrischen oder elektronischen Bauteilen zugeordnet sind, vorgesehen ist.

Diese Aufgabe wird bei einem Frequenzumrichter der gattungsgemäßen Art durch die kennzeichnenden Merkmale des Patentanspruchs 1 gelöst.

Für die Erfindung ist wesentlich, daß die Ableitung der gegenüber den übrigen elektrischen oder elektronischen Bauteilen um ein Mehrfaches oder Vielfaches höhere Verlustwärme des Leistungsmoduls über den ersten Kühlkörper erfolgt, wodurch der zweite Kühlkörper von der Abwärme des Leistungsmoduls nicht oder nur in einem vernachlässigbaren Umfang beaufschlagt wird und für die Kühlung des Gehäuseinnenraums, von dem der Raum für das Leistungsmodul abgeteilt ist, noch ein ausreichendes Temperaturgefälle zu den dortigen Bauteilen aufweist. Durch die Aufteilung der Kühlflächen auf den ersten Kühlkörper und den zweiten Kühlkörper kann auf eine erzwungene Konvektion zur Wärmeableitung, wie durch einen Motorlüfter oder einen Fremdlüfter verzichtet werden.

Vorteilhafte Ausgestaltungsmerkmale der Erfindung ergeben sich aus den Unteransprüchen.

Die Erfindung wird nachfolgend anhand der Zeichnung an einem Ausführungsbeispiel noch näher erläutert. Dabei zeigen:
- Fig. 1: eine gesprengte perspektivische Darstellung eines Frequenzumrichters gemäß der Erfindung mit dargestelltem Leistungsmodul unter Weglassung der übrigen für den Frequenzumrichter erforderlichen elektrischen und elektronischen Bauteile und
- Fig. 2: einen Schnitt durch den Frequenzumrichter gemäß Figur 1 in zusammengefügter Anordnung.

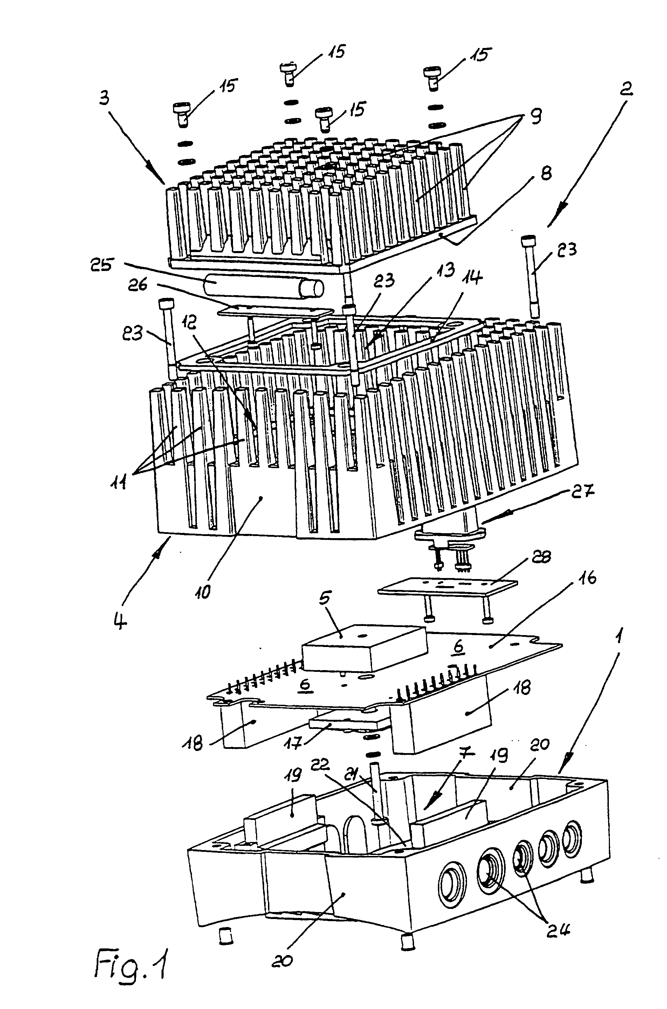

Im einzelnen erkennt man in Figur 1 ein aus drei Teilen bestehendes Gehäuse zur Aufnahme der elektrischen Teile eines Frequenzumrichters. Dieses Gehäuse besteht aus einem Gehäuseunterteil 1 und einem Gehäuseoberteil 2, wobei das Gehäuseoberteil 2 in einen ersten Kühlkörper 3 und in einen zweiten Kühlkörper 4 unterteilt ist. In zusammengefügter Anordnung umschließt das Gehäuseoberteil 2 in einem abgeteilten Raum 6 ein Leistungsmodul 5, welches im Vergleich mit den weiter für den Frequenzumrichter erforderlichen elektrischen und elektronischen Bauteilen, die im einzelnen in der Zeichnung nicht dargestellt sind, eine etwa dreimal so große, abzuführende Abwärme erzeugt. Diese übrigen elektrischen und elektronischen Bauteile sind in einem Gehäuseinnenraum 7 untergebracht, der thermisch von dem abgeteilten Raum 6, in welchem sich das Leistungsmodul 5 befindet, entkoppelt ist. Der Gehäuseinnenraum 7 wird in seinem unteren Bereich von dem Gehäuseunterteil 1 und in seinem oberen Bereich von dem zweiten Kühlkörper 4 umschlossen. So sorgt der zweite Kühlkörper 4 für die Abfuhr der Abwärme aus dem Gehäuseinnenraum 7, während der erste Kühlkörper 3 für die Kühlung des Leistungsmoduls 5 vorgesehen ist.

Der erste Kühlkörper 3 besteht aus einer Deckplatte 8, die an ihrer Außenseite eine Vielzahl von gleichmäßig verteilten Kühlfahnen 9 hat. Die Kühlfahnen 9 sind in Form von senkrecht von der Deckplatte 8 abstehenden Stacheln ausgebildet, die in Abstand voneinander angeordnet sind.

Der zweite Kühlkörper 4 des Gehäuseoberteils 2 ist kranzförmig ausgebildet, er hat entsprechend der quadratischen oder rechteckigen Grundform des ersten Kühlkörpers 3 ebenfalls eine quadratische oder rechteckige Grundrißgestalt. Entlang der Quadrat- oder Rechteckseiten hat der zweite Kühlkörper 4 durchgehende oder stellenweise verrippte Wände 10, die sich in voneinander beabstandeten Kühlfahnen 11 fortsetzen, die ebenfalls eine Stachelform aufweisen. Die Wände 10 einschließlich der Kühlfahnen 11 des zweiten Kühlkörpers 4 umschließen einen Aufnahmeraum 13 für den ersten Kühlkörper 3, der als Einsatz ausgebildet ist und in diesen Aufnahmeraum 13 des zweiten Kühlkörpers 4 eingefügt werden kann. An den Innenseiten der Wände 10 des zweiten Kühlkörpers 4 ist umlaufend ein Auflagerrahmen 12 angeformt, auf den die Deckplatte 8 des ersten Kühlkörpers 3 randlich aufgesetzt werden kann. Zuvor wird auf den Auflagerrahmen 12 innen an den Wänden 10 des zweiten Kühlkörpers 4 eine thermisch isolierende Rahmendichtung 14 aufgelegt, womit der in den Aufnahmeraum 13 eingesetzte erste Kühlkörper 3 gegenüber dem zweiten Kühlkörper 4 thermisch entkoppelt ist. Die Befestigung des ersten Kühlkörpers 3 am inneren Auflagerrahmen 12 des zweiten Kühlkörpers 4 erfolgt über Schrauben 15, wodurch die beiden Kühlkörper 3 und 4 zu einer baulichen Einheit, nämlich zum Gehäuseoberteil 2 zusammengefügt werden können.

Das Leistungsmodul 5 ist auf einer Platine 16 angeordnet, die für den elektrischen Anschluß des Leistungsmoduls 5 Kontakte hat, auf die das Leistungsmodul mit entsprechenden Gegenkontakten aufgelegt wird, wonach das Leistungsmodul 5 in seiner Lage auf der Platine 16 vorfixiert ist. Dazu sind an der Kontaktseite des Leistungsmoduls 5 und an der gegenüberliegenden Stelle der Platine 16 in der Zeichnung nicht dargestellte Formschlußelemente vorgesehen. Die Platine 16 wiederum ist mit der vom Leistungsmodul 5 abgewandten Seite auf einer Andruckplatte 17 angeordnet und diese Andruckplatte 17 kann durch die Platine 16 und durch das Leistungsmodul 5 hindurch mit dem ersten Kühlkörper 3 verschraubt werden, wozu eine Schraube 21 dient. Mittels dieser Schraube 21 kann über die Andruckplatte 17 das Leistungsmodul 5 fest an die Innenseite der Deckplatte (8) des ersten Kühlkörpers 3 angepreßt werden, wonach die Grundplatte 17 bzw. die Oberseite der Platine 16 zur Deckplatte 8 des ersten Kühlkörpers 3 einen Abstand hat, welcher durch die Höhe des Leistungsmoduls 5 bedingt ist. Durch diesen Abstand zwischen der Platine 16 und der Deckplatte 8 ist der abgeteilte Raum 6 gebildet, in dem sich das Leistungsmodul 5 befindet, welches somit seine Abwärme im Betrieb nahezu ausschließlich an den ersten Kühlkörper 3 abgibt.

Durch das Verschrauben der Andruckplatte 17 einschließlich der Platine 16 und des Leistungsmoduls 5 mit dem in den zweiten Kühlkörper 4 eingesetzten Kühlkörper 3 ergibt sich eine vormontierte Einheit, die auf das Gehäuseunterteil 1 aufgesetzt werden kann. Das Gehäuseunterteil 1 besteht aus einer Wanne, die durch randlich am Wannenboden 22 aufrechte, umlaufend geschlossene Wandungen 20 gebildet ist. Auf die Oberkanten der Wannenwandungen 20 läßt sich der zweite Kühlkörper 4 mit seinen Wänden 10 in fluchtender Richtung aufsetzen, so daß die Wände 10 des zweiten Kühlkörpers 4 die Wannenwandungen 20 fortsetzen und die Wände 10 sowie die Wannenwandungen 20 den Gehäuseinnenraum 4 umschließen. Die Verbindung des vormontierten Gehäuseoberteils 2 mit dem Gehäuseunterteil 1 erfolgt über Schrauben 23, die im Eckbereich des zweiten Kühlkörpers 4 vorgesehen sind.

Im unteren Bereich des Gehäuseinnenraums 7 innerhalb des Gehäuseunterteils 1 erfolgt die elektrische Verbindung des Frequenzumrichters zum einen mit den Motorwicklungen und zum anderen mit dem elektrischen Netz sowie mit einer optional im Gehäuseinnenraum 7 eingebauten Input-Output-Signalelektronik, die aus einem Klemmmodul und/oder verschiedenen Feld-Bus-Modulen bestehen kann. Dafür sind in den Wandungen 20 des Gehäuseunterteils Leitungsdurchführungsöffnungen 24 vorbereitet, die aufgebrochen werden können. Wie erwähnt, sind in dem Gehäuseinnenraum 7 die weiteren elektrischen und elektronischen Bauteile des Frequenzumrichters angeordnet. Ferner können im Gehäuseinnenraum 7 weitere Bedienelemente, wie Potentiometer, Netzschleifklemmen und Bremsmodule angeordnet sein, wozu ergänzende Bauteile auch an der zum Gehäuseinneren 7 hinliegenden Seite der Platine 16 vorgesehen sein können.

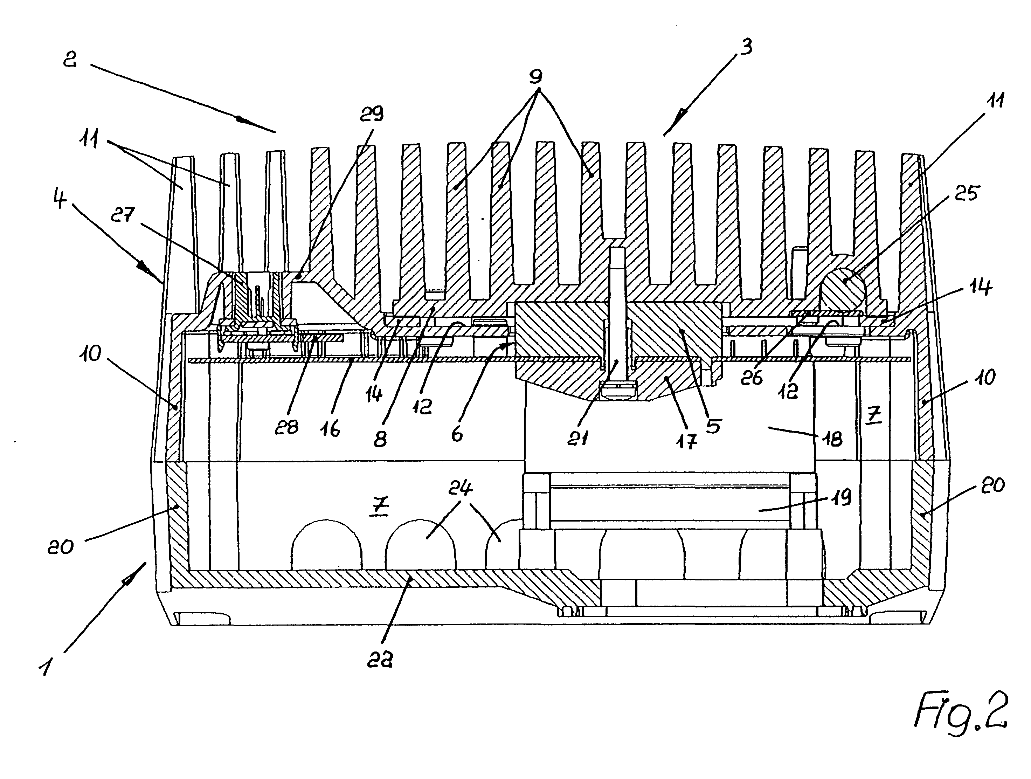

Unter den weiteren elektrischen oder elektronischen Bauteilen können sich auch solche befinden, die in besonderer Weise gekühlt werden müssen. Speist der Frequenzumrichter einen Elektromotor, der in Abständen auch generatorisch betrieben wird, dann muß die hierbei erzeugte elektrische Energie abgeführt werden. Dies geschieht durch Umwandlung in Wärme in einem Bremswiderstand 25, der in bevorzugter Ausführung mit von dem ersten Kühlkörper 3 gekühlt wird. Wie insbesondere Fig. 2 deutlich macht, ist in der montierten Anordnung der Bremswiderstand 25 in eine in die Grundplatte 8 des ersten Kühlkörpers 3 eingeformte Mulde eingebettet. Für einen guten thermischen Kontakt sorgt auch hier eine gegen den ersten Kühlkörper 3 schraubbare Anpreßplatte 26. So ist in gleicher Weise wie das Leistungsmodul 5 der Bremswiderstand 25 thermisch mit dem ersten Kühlkörper 3 verbunden, der für eine hohe Kühlleistung bzw. eine entsprechend hohe Wärmeabfuhr ausgelegt ist, was dem hohen Wärmeanfall am Bremswiderstand 25 entspricht, es versteht sich, daß auch der Bremswiderstand 25 von dem Gehäuseinnenraum 7 thermisch entkoppelt ist.

Ein besonderer Vorzug ist, daß das komplett vormontierte Gehäuseoberteil 2 mit den daran angebrachten Frequenzumrichterbauteilen, wie dem Bremswiderstand 25 und der Platine 16 mit dem Leistungsmodul 5 beim Aufsetzen auf das Gehäuseunterteil 1 sogleich elektrisch angeschlossen ist. Dazu dienen zum einen Steckverbinder 18, die sich an der zum Gehäuseunterteil 1 hinliegenden Seite der Platine in einem Bereich befinden, der nicht von der Grundplatte 17 des ersten Kühlkörpers 3 überdeckt wird. Zum anderen sind im Gehäuseinnenraum 7 des Gehäuseunterteils 1 entsprechende Gegensteckverbinder 19 vorgesehen, die beim Aufsetzen des Gehäuseoberteils 2 auf das Gehäuseunterteil 1 mit den Steckverbindern 18 an der Platine 16 in Eingriff kommen.

Die optional im Innenraum 7 eingebaute Input-Output-Elektronik wird in analoger Weise angeschlossen. So sind auch hierfür auf der Platine 16 Steckverbinder vorgesehen, die mit Gegensteckverbindern an dem optionalen Bauteil in Eingriff gebracht werden können.

Am Gehäuseoberteil 2 kann ein weiterer Steckverbinder 27 angeordnet sein, der für den externen Anschluß einer optionalen Bedieneinheit dient, und der, falls er nicht benötigt wird, mit einer Kappe verschlossen werden kann.

## Patentansprüche

1. Frequenzumrichter für einen Elektromotor mit einem aus einem Oberteil (2) und einem Unterteil (1) bestehenden Gehäuse, in dem ein Leistungsmodul (5) und weitere elektrische oder elektronische Bauteile angeordnet sind, die abzuführende Verlustwärme erzeugen, wozu das Gehäuseoberteil mit Kühlflächen versehen ist,
**dadurch gekennzeichnet,**
**daß** das Gehäuseoberteil (2) zweigeteilt ist und aus einem ersten Kühlkörper (3), der auf eine hohe Aufnahmetemperatur sowie eine hohe Wärmetauschleistung ausgelegt ist, und aus einem zweiten Kühlkörper (4) besteht, der relativ zum ersten Kühlkörper (3) auf eine geringere Aufnahmetemperatur sowie eine geringere Wärmetauschleistung ausgelegt ist, wobei das Leistungsmodul (5) in einem abgeteilten Raum (6) im Gehäuseoberteil benachbart dem ersten Kühlkörper (3) angeordnet, mit diesem thermisch leitend verbunden und dieser erste Kühlkörper (3) von dem zweiten Kühlkörper (4) thermisch entkoppelt ist und ferner der zweite Kühlkörper (4) an den übrigen Gehäuseinnenraum (7) angrenzt, in welchem die weiteren Bauteile untergebracht sind.

2. Frequenzumrichter nach Anspruch 1,
**dadurch gekennzeichnet,**
**daß** das Leistungsmodul (5) am ersten Kühlkörper (3) fest anliegend angeordnet ist.

3. Frequenzumrichter nach Anspruch 1 oder 2,
**dadurch gekennzeichnet,**
**daß** am ersten Kühlkörper (3) ein Bremswiderstand (25) für den generatorischen Betrieb des Elektromotors in gleicher Weise wie das Leistungsmodul (5) angeordnet ist.

4. Frequenzumrichter nach Anspruch 2 oder 3,
**dadurch gekennzeichnet,**
**daß** der erste Kühlkörper (3) eine außenseitig mit Kühlfahnen (9) versehene Deckplatte (8) aufweist, gegen die das Leistungsmodul (5) sowie ggf. der Bremswiderstand (25) verspannt sind.

5. Frequenzumrichter nach Anspruch 4,
**dadurch gekennzeichnet,**
**daß** der erste Kühlkörper (3) als Einsatz in den zweiten Kühlkörper (4) eingefügt ist, der einen entsprechenden Aufnahmeraum (13) umschließt, um den herum innenseitig am zweiten Kühlkörper (4) ein Auflagerrahmen (12) vorsteht, auf den der erste Kühlkörper (3) mit dem Rand seiner Deckplatte (8) unter Zwischenfügung einer thermisch isolierenden Rahmendichtung (14) aufgesetzt ist.

6. Frequenzumrichter nach Anspruch 4 oder 5,
**dadurch gekennzeichnet,**
**daß** innenseitig mit Abstand gegen die Deckplatte (8) des ersten Kühlkörpers (3)zumindest eine Andruckplatte (17, 26) geschraubt ist, zwischen der und der Deckplatte (8) das Leistungsmodul (5) und/oder der Bremswiderstand (25) verspannt sind.

7. Frequenzumrichter nach Anspruch 6,
**dadurch gekennzeichnet,**
**daß** auf der zur Deckplatte (8) hinliegenden Seite der Andruckplatte (17) für das Leistungsmodul (5) eine Platine (16) für den elektrischen Anschluß des Leistungsmoduls (5) angeordnet ist, wobei die Platine (16) und das Leistungsmodul (5) mit entsprechenden Kontakten und Gegenkontakten ausgestattet sind.

8. Frequenzumrichter nach Anspruch 7,
**dadurch gekennzeichnet,**
**daß** an die Platine (16) in einem zumindest einem über die Andruckplatte (17) für das Leistungsmodul (5) überstehenden Bereich an ihrer von der Deckplatte (8) abgewandten Seite Steckverbinder (18) fest angesetzt sind, die in Eingriff mit Gegensteckverbindern (19) im Gehäuseunterteil (1) stehen.

9. Frequenzumrichter nach einem der Ansprüche 5 bis 8,
**dadurch gekennzeichnet,**
**daß** das Gehäuseunterteil (1) aus einer Wanne mit umlaufend geschlossenen Wandungen (20) besteht, auf die der zweite Kühlkörper (4) aufgesetzt ist, wobei der zweite Kühlkörper (4) über den umgebenen, abgeteilten Raum (6) für das Leistungsmodul (5) vorstehende Wände (10) hat, die in Fortsetzung der Wandungen (20) der Wanne (1) den übrigen Gehäuseinnenraum (7) umschließen.

10. Frequenzumrichter nach einem der Ansprüche 1 - 9,
**dadurch gekennzeichnet,**
**daß** im Gehäuseinnenraum (7) die weiteren elektrischen und/oder elektronischen Bauteile angeordnet sind.

11. Frequenzumrichter nach Anspruch 10,
**dadurch gekennzeichnet,**
**daß** die im Gehäuseinnenraum (7) angeordneten weiteren Bauteile mit Steckverbindern auf der Platine (16) und mit Gegensteckverbindern an diesen Bauteilen elektrisch angeschlossen sind, wobei diese Steckverbinder und Gegensteckverbinder analog den Steckverbindern (18) und den Gegensteckverbindern (19) entsprechen.

12. Frequenzumrichter nach Anspruch 10,
**dadurch gekennzeichnet,**
**daß** die weiteren Bauteile zum Teil gegen den zweiten Kühlkörper (4) wärmeleitend verspannt sind.

13. Frequenzumrichter nach einem der Ansprüche 5 bis 12,
**dadurch gekennzeichnet,**
**daß** der zweite Kühlkörper (4) den ersten Kühlkörper (3) kranzförmig umgibt und eigene Kühlfahnen (11) in gleicher Ausrichtung mit den Kühlfahnen (9) der Deckplatte (8) des ersten Kühlkörpers (3) hat.

## Claims

1. Frequency converter for an electric motor with a housing consisting of an upper part (2) and a lower part (1), in which are arranged a power module (5) and further electrical or electronic components that generate heat loss that needs to be dissipated, for which purpose the upper part of the housing is provided with cooling surfaces,
**characterised in that**
the upper part (2) of the housing is divided in two and consists of a first heat sink (3) configured for a high pick-up temperature and high heat exchange performance, and a second heat sink (4) configured for a lower pick-up temperature and lower heat exchange performance than the first heat sink (3), the power module (5) being arranged adjacent to the first heat sink (3) in a partitioned-off space (6) in the upper part of the housing and being coupled therewith in a thermally conductive manner, this first heat sink (3) being thermally isolated from the second heat sink (4), and the second heat sink (4) also adjoining the remainder of the interior (7) of the housing, in which the further components are accommodated.

2. Frequency converter according to claim 1,
**characterised in that**
the power module (5) is rigidly attached to the first heat sink (3).

3. Frequency converter according to either claim 1 or claim 2,
**characterised in that**
a braking resistor (25) for generator mode of the electric motor is arranged on the first heat sink (3) in the same manner as the power module (5).

4. Frequency converter according to either claim 2 or claim 3,
**characterised in that**
the first heat sink (3) comprises a cover plate (8) provided on the outside with cooling vanes (9), against which plate the power module (5) and optionally the braking resistor (25) are fixed.

5. Frequency converter according to claim 4,
**characterised in that**
the first heat sink (3) is inserted as an insert into the second heat sink (4) which surrounds a corresponding receiving space (13) around which, on the inside of the second heat sink (4), a supporting frame (12) projects, on which frame the first heat sink (3) is placed with the edge of its cover plate (8) with interposition of a thermally insulating frame seal (14).

6. Frequency converter according to either claim 4 or claim 5,
**characterised in that**,
on the inside and with spacing, at least one pressure plate (17, 26) is screwed against the cover plate (8) of the first heat sink (3), the power module (5) and/or the braking resistor (25) being fixed between the pressure plate (17, 26) and the cover plate (8).

7. Frequency converter according to claim 6,
**characterised in that**
on the side, facing the cover plate (8), of the pressure plate (17) for the power module (5) is arranged a printed circuit board (16) for the electrical connection of the power module (5), the printed circuit board (16) and the power module (5) being equipped with corresponding contacts and counter contacts.

8. Frequency converter according to claim 7,
**characterised in that**
connectors (18), engaging with counter connectors (19) in the lower part (1) of the housing, are rigidly attached to the printed circuit board (16) in at least one region projecting beyond the pressure plate (17) for the power module (5) and at its side remote from the cover plate (8).

9. Frequency converter according to any one of claims 5 to 8,
**characterised in that**
the lower part (1) of the housing comprises a trough with peripherally closed walls (20) on which the second heat sink (4) is placed, the second heat sink (4) having walls (10) projecting beyond the surrounded partitioned-off space (6) for the power module (5), these walls (10), as a continuation of the walls (20) of the trough (1), surrounding the remainder of the interior (7) of the housing.

10. Frequency converter according to any one of claims 1 to 9,
**characterised in that**
the further electrical and/or electronic components are arranged in the interior (7) of the housing.

11. Frequency converter according to claim 10,
**characterised in that**
the further components arranged in the interior (7) of the housing are electrically connected with connectors on the printed circuit board (16) and with counter connectors on these components, these connectors and counter connectors similarly corresponding to the connectors (18) and counter connectors (19).

12. Frequency converter according to claim 10,
**characterised in that**
some of the further components are fixed against the second heat sink (4) in a heat conducting manner.

13. Frequency converter according to any one of claims 5 to 12,
**characterised in that**
the second heat sink (4) annularly surrounds the first heat sink (3) and has its own cooling vanes (11) with the same orientation as the cooling vanes (9) of the cover plate (8) of the first heat sink (3).

## Revendications

1. Convertisseur de fréquence pour un moteur électrique, avec un boîtier qui consiste en une partie supérieure (2) et en une partie inférieure (1), dans lequel sont disposés un module de puissance (5) et d'autres éléments constitutifs, électriques ou électroniques qui génèrent de la chaleur perdue à évacuer, ce pourquoi la partie supérieure du boîtier est pourvue de surface de refroidissement,
**caractérisé en ce que**
la partie supérieure (2) du boîtier est divisée en deux et consiste en un premier corps dissipateur de chaleur ? Corps dissipateur de chaleur) (3), qui est dimensionné pour une température d'absorption élevée ainsi que pour une puissance d'échange thermique élevée, et en un deuxième corps dissipateur de chaleur (4) qui, par rapport au premier corps dissipateur de chaleur (3) est dimensionné pour une température d'absorption plus faible et pour une puissance d'échange thermique plus faible, le module de puissance (5) étant disposé, dans la partie supérieure du boîtier, dans une chambre séparée (6), dans le voisinage du premier dissipateur de chaleur (3) et relié en conduction thermique avec celui-ci, et ce premier Corps dissipateur de chaleur (3) étant désaccouplé thermiquement du deuxième dissipateur de chaleur (4), et le deuxième dissipateur de chaleur (4) étant en outre contigu au reste de l'espace intérieur (7) du boîtier, dans lequel sont logés les autres éléments constitutifs.

2. Convertisseur de fréquence selon la revendication 1,
**caractérisé en ce que**
le module de puissance (5) est disposé de façon à être en contact fixe avec le premier dissipateur de chaleur (3)

3. Convertisseur de fréquence selon la revendication 1 ou 2,
**caractérisé en ce que**,
sur le premier dissipateur de chaleur (3), une résistance de freinage (25), pour l'exploitation en génératrice du moteur électrique, est disposée de la même manière que le module de puissance (5).

4. Convertisseur de fréquence selon la revendication 2 ou 3,
**caractérisé en ce que**
Le premier dissipateur de chaleur (3) présente une plaque de recouvrement (8) pourvue à l'extérieur d'ailettes de refroidissement (9), contre laquelle le module de puissance (5) ainsi que, le cas échéant, la résistance de freinage (25) sont calés.

5. Convertisseur de fréquence selon la revendication 4,
**caractérisé en ce que**
le premier dissipateur de chaleur (3) est introduit en tant qu'insert dans le deuxième dissipateur de chaleur (4) qui renferme un réceptacle (13) adéquat, autour duquel, sur le côté intérieur du deuxième dissipateur de chaleur (4), fait saillie un cadre d'appui (12), sur lequel le premier dissipateur de chaleur (3) repose avec le bord de sa plaque de recouvrement (8), un joint d'isolation thermique (14) étant intercalé.

6. Convertisseur de fréquence selon la revendication 4 ou 5,
**caractérisé en ce que**,
sur le côté intérieur, à intervalle, contre la plaque de recouvrement (8) du premier dissipateur de chaleur (3), au moins une plaque de pression (17, 26) est vissée, entre laquelle et la plaque de recouvrement (8), le module de puissance (5) et / ou la résistance de freinage (25) sont calés.

7. Convertisseur de fréquence selon la revendication 6,
**caractérisé en ce que**,
sur le côté de la plaque de pression (17), orienté vers la plaque de recouvrement (8) pour le module de puissance (5), une platine (16) est disposée pour le raccordement électrique du module de puissance (5), ladite platine (16) et ledit module de puissance (5) étant équipés de contacts mâles et femelles correspondants.

8. Convertisseur de fréquence selon la revendication 7,
**caractérisé en ce que**,
sur la platine (16), dans au moins un domaine en saillie au-dessus de la plaque de pression (17) pour le module de puissance (5), sur le côté orienté à l'opposé de la plaque de recouvrement (8), sont placés des connecteurs à fiches (18) qui entrent en prise avec des connecteurs à contre-fiches (19), dans la partie inférieure (1) du boîtier.

9. Convertisseur de fréquence selon l'une des revendications 5 à 8,
**caractérisé en ce que**
la partie inférieure (1) du boîtier consiste en une cuvette avec des parois périphériques, fermées (20), sur laquelle le deuxième dissipateur de chaleur (4) est placé, ledit deuxième dissipateur de chaleur (4) étant pourvu de parois (20) qui font saillie au-dessus de l'espace périphérique, divisé (6) pour le module de puissance (5), lesquelles parois (10) entourent le reste de l'espace intérieur (7) du boîtier, en prolongement des parois (20) de la cuvette (1).

10. Convertisseur de fréquence selon l'une des revendications 1 à 9,
**caractérisé en ce que**,
dans l'espace intérieur (7) du boîtier, sont disposés les autres éléments constitutifs électriques et / ou électroniques.

11. Convertisseur de fréquence selon la revendications 10,
**caractérisé en ce que**
les autres éléments constitutifs, disposés dans l'espace intérieur (7) du boîtier, sont raccordés électriquement avec des connecteurs à fiches équipant la platine (16) et avec des connecteurs à contre-fiches équipant lesdits éléments constitutifs, lesdits connecteurs à fiches mâles et femelles correspondant de façon analogue aux connecteurs à fiches (18) et aux connecteurs à contre-fiches (19).

12. Convertisseur de fréquence selon la revendications 10,
**caractérisé en ce que**
les autres éléments constitutifs sont partiellement calés, en conduction thermique, contre le deuxième dissipateur de chaleur (4).

13. Convertisseur de fréquence selon l'une des revendications 5 à 12,
**caractérisé en ce que**
le deuxième dissipateur de chaleur (4) entoure en forme de couronne le premier dissipateur de chaleur (3) et possède ses propres ailettes de refroidissement (9) qui sont orientées dans la même direction que les ailettes de refroidissement (9) de la plaque de recouvrement du premier dissipateur de chaleur (3).
